# EUROPEAN PATENT SPECIFICATION

(11) **EP 2 159 302 B1**
(45) Date of publication and mention of the grant of the patent: **09.12.2015**
(21) Application number: 08162906.5
(22) Date of filing: 25.08.2008
(51) Int. Cl.: B65G 49/06, C23C 14/56, C23C 16/54, C23C 16/44

(54) **Coating chamber with a moveable shield**
Beschichtungskammer mit beweglichem Schirm
Chambre de revêtement avec écran mobile

(43) Date of publication of application: 03.03.2010
(73) Proprietor: Applied Materials, Inc., Santa Clara, CA 95054 (US)
(72) Inventor: Wolf, Hans, 63526 Erlensee (DE); Lindenberg, Ralph, 63654 Büdingen (DE)
(74) Representative: Zimmermann & Partner Patentanwälte mbB

(56) References cited:
- EP-A- 0 553 691
- EP-A- 0 709 486
- US-A- 5 738 767
- US-A1- 2003 146 085
- US-A1- 2006 105 182

## Description

### BACKGROUND OF THE INVENTION

### FIELD OF THE INVENTION

The invention refers to a coating chamber as well as a method of operating a coating chamber, and especially a vacuum coating chamber in which thin film deposition techniques like chemical vapour deposition CVD processes, plasma enhanced chemical vapour deposition PECVD processes, physical vapour deposition PVD processes or sputter processes may be carried out.

### PRIOR ART

Coating techniques are widely used in industry for the production of different products. For example glass substrates for architectural use or for use in connection with displays, like thin film transistor TFT displays, organic light emitting diode OLED displays etc. have to be coated with thin films.

For all these products it is desirable that homogeneous and uniform coatings are achieved. In addition, high efficiency of the coating processes is necessary to keep the costs low and to obtain competitive results. Accordingly, various methods and apparatuses have been suggested in prior art to obtain high quality coatings at reasonable prices.

The various methods for carrying out the deposition of coatings may be divided into three different types. The first type is stationary coating of a substrate. According to this type the substrate to be coated is kept at a single coating position during the whole coating process. Thus, the coating area defined by the coating source has to cover the whole surface to be coated. Although this method is very simple and thus cost efficient and may also be suitable for various applications, this method suffers from the disadvantage that the deposited coating may not be homogeneous and uniform over the entire surface, since due to the spatial conditions different areas of the substrate surface may be coated differently. Especially at the edges of the surface problems may arise.

The second type of coating may be designated as a continuous coating and is characterized by the fact that the substrate to be coated is continuously moved through the coating area defined by the coating source by means of movable substrate carriers. By doing this, large area substrates like architectural glass may be homogeneously coated, since due to the continuous movement of the substrate every point of the surface to be coated runs through the different areas of the coating area so that at least along the transport direction similar coating conditions are achieved at the whole substrate surface. However, this method is more laborious, since a transport device, which allows a continuous movement of the substrate, has to be provided for. In order to protect the expansive equipment, as the transport device and the substrate carrier, from being coated, shields have to be provided for. According to prior art, shields arranged at the substrate carriers for protecting the substrate carriers as well a shield fixedly arranged in the coating chamber for protecting the transport mechanism have to be provided for. The same holds true for the third type of deposition process wherein the substrate is moved to different coating positions or is oscillated during the coating process. However, due to the additional shields apparatuses for such coating methods are more expensive. Moreover, the operation of corresponding apparatuses may lead to problems associated with cleaning of the substrate carriers and their shields which has to be carried out after each run through different coating stations.

A substrate processing reactor comprising a vertically movable susceptor beneath a showerhead is disclosed in documents EP 0553691 A1 and EP 0709486 A1. The devices described therein comprise a shield ring which normally rests on a ring support in the chamber. However, the shield ring may be lifted by the susceptor when the susceptor is moved vertically.

### DISCLOSURE OF THE INVENTION

### OBJECT OF THE INVENTION

It is therefore an object of the present invention to provide a coating chamber as well as a method for operation of a coating chamber which allows high quality deposition of coatings especially with respect to homogeneity and uniformity of the deposited coating while at the same time the effort is minimized. Moreover, the coating chamber should be sample in design and production as well as variable in use. Though high variability of use, the operation should also be easy.

### TECHNICAL SOLUTION

These objects are achieved by a coating chamber having the features of claim 1 as well as a method of operating a coating chamber having the features of claim 29. Further embodiments are subject matter of the dependent claims.

The solution of the present invention is characterized by the fact that in a coating chamber having a coating source and a transport device for moving a substrate carrier through the coating chamber at least one movable shield is provided for, which comprises a moving apparatus and a coupling device for coupling the shield and the substrate carrier, so that the shield and the substrate carrier are moveable together. Due to this design, it is possible to omit the shields arranged at the substrate carriers, which considerably reduces effort, since not only one shield can be saved, but a plurality of shields according to the plurality of substrate carriers used at the same time in a corresponding coating apparatus.

Moreover, the variability of use of such a coating chamber is increased, since all different types or modi of operation can be performed by such a coating chamber. When the shield is kept stationary, stationary coating can be performed. In the case of semi-stationary coating, i. e. especially in case of oscillating coating, wherein the substrate is oscillated in front of the coating source, and in case of continuous coating the shield can be moved together with the substrate carrier carrying the substrate to be coated. By means of the coupling device the movable shield is attached to the substrate carrier like a mask. However, the movable shield is only coupled to the substrate carrier during the coating process in this coating chamber. Accordingly, the movement of the shield can be restricted to an area close to the coating area, wherein the coating area may be defined as an area where the deposition rate is higher than a predetermined value. Especially, the moving apparatus of the shield may be designed such that the shield is only moveable in the chamber, but can not be moved into the chamber or out of the chamber by means of the moving apparatus.

The coating chamber according to the present invention may be used for different deposition technologies and may be especially designed as a vacuum chamber for carrying out vacuum deposition techniques like chemical vapour deposition CVD, plasma enhanced chemical vapour deposition PECVD, physical vapour deposition PVD and especially sputter processes.

However, other deposition techniques like vapour deposition by thermal evaporation may also be used. Accordingly, the coating chamber may comprise a coating source designed for such depositing technologies. Especially, the coating source may comprise treatment tools including electrodes, magnetron electrodes, showerhead electrodes, rotatable electrodes, twin electrodes, microwave sources, heaters, sputter targets, gas inlets, and evaporation sources etc. as well as combinations thereof. In general, all the treatment tools necessary for depositing a layer or performing a coating process may be included in or attached to the coating chamber. The coating source may comprise only a single treatment tool like a sputter magnetron electrode, a so called line source, or may comprise several treatment tools in order to form a coating source extending over a specific area of the coating chamber. Such a two-dimensional coating source may for example comprise an array of electrodes arranged adjacent to each other side by side so that bigger coating areas can be achieved. Especially, the electrodes may be arranged with their longitudinal axes parallel to each other transverse to the transport direction of the substrate. Accordingly, a substrate having smaller dimensions than the dimensions of the two-dimensional coating source may be coated by a stationary coating process while a substrate with a surface to be coated which is bigger in the transport direction than the extension of the two-dimensional coating source may be coated in a semi-stationary or a continuous coating process.

Preferably, the extension of the coating source in the length direction is chosen such that in this dimension the dimension of the substrate to be coated is smaller than the coating source. Thus, in this direction whole coverage of the surface to be coated by the coating source is assured. Accordingly, the transport direction for semi-stationary or continuous coating should be chosen in a direction transverse to the length direction in order to cover all other areas of the substrate to be coated by an appropriate movement of the substrate.

The transport device may comprise a drive and / or a guide device. By the drive the substrate carrier is driven to perform the movement of the substrate for semi-stationary or continuous coating. In order to facilitate the movement, the guide device may guide and support the substrate carrier during movement.

While the present invention is suitable for both horizontal as well as vertical transport of the substrates, specific embodiments are especially designed for upright transport of plate-like substrates like glass substrates or the like.

The guide device of the transport device may comprise a support defining a transport path and an opposing guide rail for engagement with the substrate carrier. The support may be formed by support rolls on which the substrate carrier is moved. Some of the support rolls may simultaneously be formed as drive rolls for driving the substrate carrier. The guide device may comprise a contactless guide, especially a magnetic guide wherein due to magnetic forces the substrate carrier is guided in a guide rail with a distance to the walls of the rail.

According to another embodiment, the transport device may comprise several guide devices defining several transport paths. Thus, several substrate carriers may be moved in the transport device simultaneously. By this measure the throughput can be advantageously increased.

The several transport paths may be arranged parallel to each other. By parallel arrangement of the transport paths the interaction of the substrate carriers to be moved on the transport paths with the other components of the coating chamber is facilitated.

The moving apparatus for the moveable shield may be designed in a similar way as the transport device. Accordingly, the moving apparatus may comprise at least one drive and at least one guide apparatus.

The moving apparatus may be adapted for moving a ring-like shield surrounding a coating area or for moving of a band-like shield and / or of several shields.

The guide apparatus of the moving apparatus may comprise a shield support defining a shield transport path and opposing shield guide rails.

The moving apparatus may also comprise rolls for supporting and / or driving the shield similar to the rolls for supporting and / or driving substrate carriers at the transport device. Accordingly, some of the rolls may also be drive rolls for driving the shield.

The transport device and the moving apparatus may have a single common drive or several independent drives. A single common drive has the advantage that synchronisation of the movement can be achieved easily.

The coupling device for coupling a moveable shield and the substrate carrier may comprise different coupling means for coupling the moveable shield and the substrate carrier. One kind of connection, which allows for easy handling, is realized by a form fit connection. Accordingly, the coupling device may comprise form fit elements like pins and corresponding recesses or the like.

In order to couple the shield and the substrate carrier, form fit elements may be engaged to each other. This can easily be achieved by movement of the transport device and / or the moving apparatus relative to each other, at least for parts of these devices and apparatuses. Such a movement is in the direction of the coating source, i.e. transverse to the transport direction of the substrate carrier. In order to facilitate movement of the transport device and / or the moving apparatus relative to each other, the guide rails may be arranged at different levels with respect to the transport path of the transport device and / or the moving apparatus. Thus, the rails do not clash during reciprocal movement. In this respect the guide rails of the transport device or the guide rails of the moving apparatus may be arranged at a greater distance to the transport path than the other.

In addition to the first moveable shield a second shield which is fixed with respect to the coating source may be arranged for protecting the moving apparatus as well as the movable shield.

Due to the design of the coating chamber of the present invention, the coating chamber can be used in different ways so that the variability of use is enhanced. Especially, the coating chamber may be used for a stationary coating, continuous coating as well as semi-stationary coating. Due to movability of the shield, in each operation mode high quality coatings with respect to uniformity and homogeneity can be deposited.

### SHORT DESCRIPTION OF THE FIGURES

Further advantages, features and characteristics of the present invention will become apparent from the following description of embodiments with respect to the attached drawings. The drawings show in pure schematic form in
- Figure 1: a cross sectional view of a part of a coating chamber according to the first embodiment of the invention;
- Figure 2: a cross sectional view of parts of the coating chamber shown in figure 1 in a second operation status;
- Figure 3: a cross sectional view of parts of the coating chamber according to figures 1 and 2 in a third operation status:
- Figure 4: a cross sectional view of parts of the coating chamber according to the figures 1 to 3 in a fourth operation status;
- Figure 5: a cross sectional view of a part of a coating chamber according to a second embodiment of the present invention;
- Figure 6: a cross sectional view of a part of the coating chamber according to figure 5 in a second operation status;
- Figure 7: a cross sectional view of a part of a coating chamber according to a third embodiment of the present invention; and in
- Figure 8: a cross sectional view of a part of the coating chamber according to figure 7 in a second operation status.

### DETAILED EMBODIMENTS

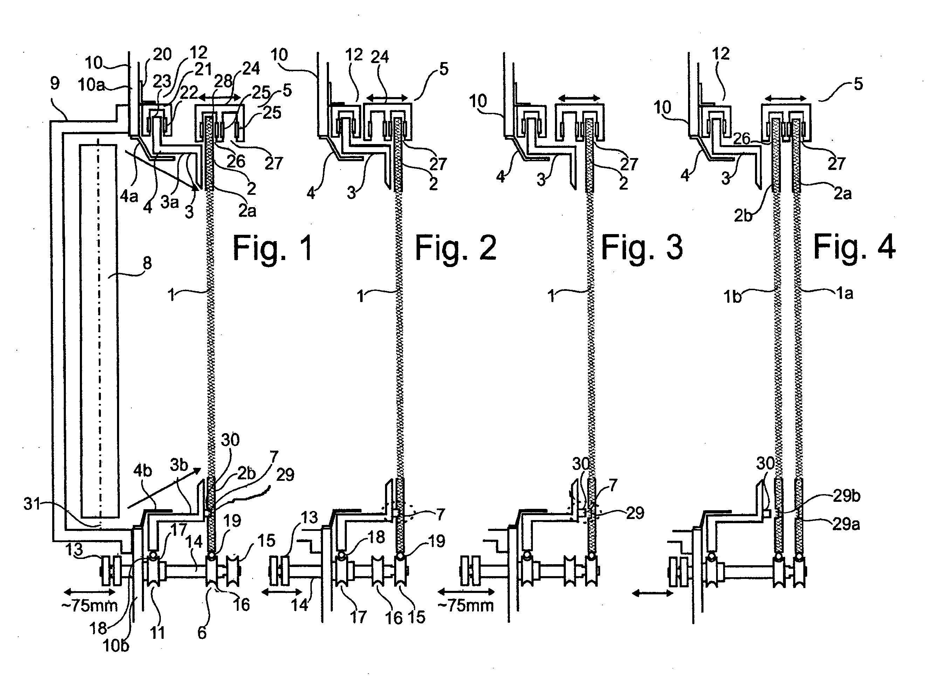

Figure 1 shows a part of a coating chamber according to the first embodiment of the present invention in a cross sectional view. The coating chamber of the embodiment shown in figure 1 comprises a chamber wall 10 which can only be seen partially. According to the cross section the chamber wall 10 is divided into the upper chamber wall part 10a and the lower chamber wall part 10b. The chamber wall parts 10a and 10b define an opening which is closed by a lid 9. At the lid 9 a coating source 8 is arranged, for example a rotatable magnetron cathode for sputter deposition. Due to the detachably arranged lid 9 the coating source 8 can easily be exchanged.

Opposite to the coating source 8 the substrate 1 being contained in a substrate carrier 2 can be disposed via a transport device 5.

According to the cross sectional view the substrate carrier 2 is shown in two parts 2a and 2b. However, it is to be understood that the substrate carrier may be formed as a surrounding frame or a plate-like receiver. Other embodiments for carrying a substrate are also conceivable.

The transport device 5 for supporting and moving of the substrate carrier 2 comprises a guide device 6 and a drive 13. The guide device 6 includes an upper guide rail 24 and lower support rolls 15, 16. The bearing surface of the support rolls 15, 16 comprise a circumferential recess to engage a sliding element 19 provided at the lower end of the substrate carrier 2.

As can be seen from figure 1, the guide device comprises two support rolls 15, 16 as well as a guide rail 24 designed as a double guide rail comprising two engagement channels 26 and 27 for receiving the upper end 28 of the substrate carrier. Accordingly, the guide rail 24 is designed as a profile to have the cross sectional shape of an E.

The upper end 28 of the substrate carrier 2 is engaging in one of the engagement channels 26 and 27. In figure 1 the substrate carrier 2 is shown which is engaged in the engagement channel 26 of the guide rail 24, while engagement channel 27 is not used.

In order to provide a contactless guide, magnets 25 are arranged at the side walls of the engagement channels 26 and 27 so as to keep the upper end of the substrate carrier 2 engaging with the engagement channels 26, 27 at a distance to the side walls of the engagement channels 26, 27. For this purpose, the substrate carrier 2 may also comprise appropriate magnets or may be formed of an appropriate material.

In the embodiment of figure 1 the substrate carrier 2 is supported by the support roll 16 and engaged in the engagement channel 26 of the guide rail 24. However, a second substrate carrier (not shown) may be disposed at the second support roll 15 as well as in the engagement channel 27, so that a second parallel transport path is defined by the support roll 15 and the engagement channel 27 in addition to the first transport path defined by the support roll 16 and the engagement channel 26.

The support rolls 15 and 16 are arranged on a rotatable shaft 14 which is driven by a drive roll 13 that is connected to a motor (not shown). Accordingly, when the drive roll 13 is rotated, the support rolls 15, 16 are also driven by the rotatable shaft in order to move the substrate carriers 2 arranged on the support rolls 15, 16.

Similar to the guide rail 24, which is extending in the direction perpendicular to the plotting plane or cross sectional plane, several support rolls 15, 16 are arranged adjacent to each other side by side in the direction perpendicular to the plotting plane in order to support and / or drive the plate-like substrate 1 or the substrate carrier 2, respectively, in the direction perpendicular to the plotting plane or cross sectional plane.

Although all support rolls may be driven by a drive, it is not necessary to drive all support rolls, since due to the extension of the substrate carrier 2 it is sufficient to drive only some of the support rolls arranged in a line.

By means of the transport device 5 the substrate carrier 2 can be moved together with a substrate 1 in a direction perpendicular to the plotting plane, so that the substrate 1 may be arranged in one or more coating positions opposite to the coating source 8 or may be moved such that the substrate is passing the coating source 8 once or several times.

Since the coating source 8 is designed such that the extension in the length direction 31 is at least the same or even bigger than the extension of the substrate 1 to be coated, the substrate 1 may be coated completely in this direction when being arranged opposite to the coating source 8. However, due to a larger extension of the substrate 1 to be coated in the direction perpendicular to the length direction of the coating source, i.e. the direction perpendicular to the plotting plane, the substrate 1 may not be completely coated in this direction. Accordingly, the substrate may be moved during deposition by the transport device 5, so that during movement the whole surface of the substrate is running through the coating area defined by the coating source 8 and thus being completely coated. Alternatively, it is possible to provide several coating sources 8 in an array, so that the coating area of the coating source at all is increased to cover the whole substrate surface to be coated. For example, the plurality of treatment tools forming such an enlarged coating source may be arranged in a row in the direction perpendicular to the plotting plane. In one embodiment a series of rotatable magnetron electrodes may be arranged adjacent to each other side by side with the length direction 31 being parallel.

Thus, depending on the coating conditions the substrate 1 may be coated in a stationary mode with the substrate carrier 2 and the substrate 1 being held in a single position during the whole coating process or in several coating positions. Alternatively, the substrate carrier 2 and the substrate 1 may be continuously moved in one transport direction during coating or in an oscillating way with alternating transport directions.

In order to prevent the substrate carrier 2, the transport device 5 and / or other components of the coating chamber from being coated undesirably, a movable shield 3 associated to the coating chamber is arranged at the coating chamber wall. The shield 3 has a ring-like shape surrounding a coating area, wherein the upper part 3a and the lower part 3b can only be seen due to the cross sectional view of figures 1 to 4. Alternatively, other shapes of the shield may be considerable like structures comprising only a shield function in the upper and lower part with band-like shapes or the like. The cross section of the shield 3 shown in figure 1 is cup-like or flange-like structure having an opening to provide a coating aperture.

Although the shield 3 may be used in a stationary way, i. e. the shield is kept immovable during the deposition, the shield 3 is arranged in a moving apparatus 11 similar to the transport device 5 for the substrate carrier 2 to provide the ability to move.

The moving apparatus comprises a shield guide device 12 and a drive 13 which is commonly used with the transport device 5. The shield guide device 12 comprises a support roll 17 similar to the support rolls 15, 16 of the transport device as well as a shield guide rail 21 similar to part of the guide rail 24 of the transport device 5. The shield guide rail 21 only comprises one engagement channel wherein the upper part 23 of the shield 3 is engaged in a contactless manner.

For this purpose the shield guide rail 21 also comprises magnets 22 at the side walls of the engagement channel. In the cross section the shield guide rail 21 has the shape of an U. The shield guide rail 21 is fixed to the chamber wall 10 by elbows 20.

At the lower part the shield 3 is supported on the support roll 17 which also comprises a recess in the bearing surface. Similar to the substrate carrier 2 the shield 3 comprises a sliding element 18 to engage with the recess of the support roll 17.

The support roll 17 is arranged at the shaft 14 in a torque-proof manner, so that the support roll 17 can be driven by the drive roll 13. In addition, the support roll 17 can slide along the longitudinal axes of the shaft 14, so that the shaft 14 may be moved according to the double arrow shown in the lower left part of figure 1. For this purpose, the shaft is slidably disposed in the chamber wall 10.

Similar to the movement of the shaft 14 the guide rail 24 of the transport device 5 of the substrate carrier 2 may be moved according to the double arrow shown in the upper right part of figure 1. Since the support rolls 15, 16 are fixedly arranged at the shaft 14, the support rolls 15, 16 are moved together with the shaft 14, when the shaft 14 is moved according to the double arrow. The guide rail 24 is coupled to the shaft 14 in order to synchronously move the guide rail 24 with the shaft 14.

As can also be seen from figure 1, a coupling device 7 is provided to couple the shield 3 and the substrate carrier 2. The coupling device 7 comprises a pin 30 which may engage in a recess 29 provided in the substrate carrier 2 to provide a form fit connection. Due to the movement of the shaft 14 and consequently of the support roll 16 as well as the guide rail 24, the substrate carrier 2 can be moved such that the pin 30 of the shield 3 is engaging the recess 29. Thus, a coupling of the shield 3 and the substrate carrier 2 can be achieved. When the substrate carrier 2 and the shield 3 are coupled together by the coupling device 7, the shield 3 and the substrate carrier 2 can be moved together by the transport device 5 and the moving apparatus 11. Thus, in the modi of operation where a movement of the substrate carrier 2 and the shield 3 is carried out during the coating process, a movable shielding may be established in a simple manner only for the coating process by coupling of the shield 3 and the substrate carrier 2. Thus, the entire surface of the substrate 1 may be coated by the coating source 8, although the coating area defined by the coating source 8 does not cover the whole surface to be coated. Especially, the substrate carrier and the shield 3 may be oscillated during the position so that a homogeneous and uniform coating may be achieved. Since the movable shield 3 is associated to the coating chamber, the shield 3 has not to be moved with the substrate carrier 2 out of the coating chamber after deposition and to be re-introduced with a new substrate to be coated. Moreover, the number of shields may be reduced. Further, the movable shield may not only be used in an operation mode during which movement of the substrate occurs, but also for stationary coating.

In order to protect the moving apparatus 11 from deposition of coating material, a second shield 4 is fixed to the chamber wall 10. Similar to the shield 3 the second shield 4 is not restricted to upper and lower shield bands 4a and 4b as shown in the cross sectional views of figures 1 to 4, but may comprise a ring structure.

According to the design of the inventive coating chamber three different operation modi are possible, namely stationary coating with the substrate 1 in one coating position during the whole coating process, continuous coating with the substrate 1 being continuously moved during the coating process in one direction and a third operation mode where the substrate 1 is moved into different coating positions during the coating especially in an oscillating manner. For all three operation modi the shield 3 provides an appropriate protection from deposition of coating material at undesired areas while simultaneously high quality deposition of a coating, especially with respect to homogeneity and uniformity of the deposited coating, is achieved. While during the stationary operation the shield 3 is in a stationary position, the shield 3 may be moved with the substrate carrier 2 in a continuous and a semi-stationary operation mode, during which the substrate 1 is moved into several different coating positions or is oscillated during the coating process.

The figures 2 to 4 show the same coating chamber as in figure 1 with the only difference that in the figures 2 to4 the lid 9 and the coating source 8 are not shown.

Furthermore, figure 2 shows the arrangement of the substrate carrier 2 and the substrate 1 in the second transport path with the support roll 15 and the engagement channel 27. Due to the displacement of the shaft 14 and the guide rail 24 the substrate carrier 2 and the shield 3 are also coupled by the coupling device 7.

Due to provision of two parallel transport paths by the transport device 5 a high throughput of substrates is possible, since one substrate can be arranged in at least one coating position while the other substrate is removed from a coating position.

Figure 4 shows such a situation where two substrates 1a and 1b are transported by the transport device 5 in the two transport paths provided by the transport device 5. Accordingly, the pin 30 is not engaged in recesses 29b and 29a of the substrate carriers 2a and 2b as it is also shown in figure 3.

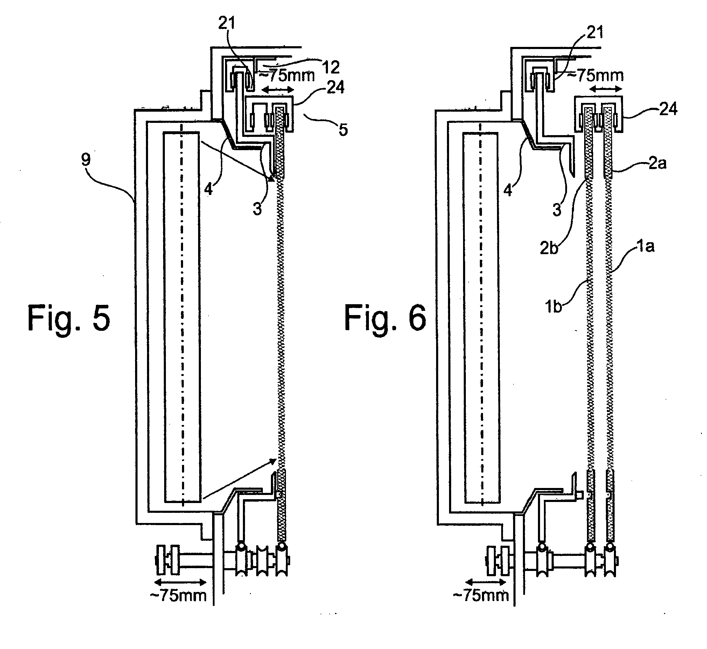

Figures 5 and 6 show cross sectional views of a second embodiment of the present invention which is in most parts similar to the embodiments shown in figures 1 to4. Accordingly, a repeated description of the whole embodiment is omitted for the sake of simplicity. Only the differences are explained below.

The embodiments shown in figures 5 and 6 differ from the embodiments shown in figures 1 to 4 by the arrangement of the shield guide rail 21 of the shield guide device 12 and the guide rail 24 of the transport device 5. According to the embodiment of figures 5 and 6 the shield guide rail 21 is not disposed side by side with the guide rail 24 in the coating direction, but above the guide rail with respect to the support or the shaft. Thus, a space saving design is achieved, since the guide rail 24 can be moved more close to the shield 3.

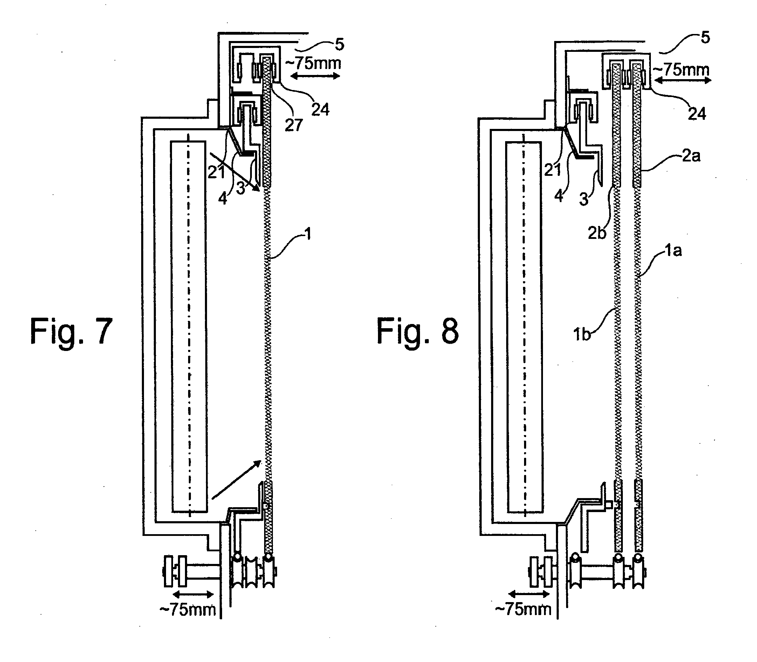

A similar embodiment is shown in figures 7 and 8. In this embodiment the rail guide 24 is arranged above the shield guide rail 21 so that especially in the situation, when the engagement channel 27 of the rail guide 24 is used, a very space saving arrangement of the transport device 5 can be achieved.

Although the present invention has been described with respect to the specific embodiments, it is evident for a man skilled in the art that the invention is not restricted to these embodiments, but covers also alterations and modifications, for example by omitting single features or by different combination of the features shown, without leaving the scope of the attached claims. Especially, the invention covers all combinations of features described herein.

## Claims

1. Coating chamber comprising:
a coating source (8),
a transport device (5) for moving a substrate carrier (2) adapted to be able to carry a substrate (1) to be coated into at least one coating position with respect to the coating source (8) so that the substrate (1) may be coated, the transport device (5) being movable in a direction transverse a coating direction with the coating direction extending from the coating source to the substrate and
at least one first shield (3) being movably arranged in an area between the coating position of the substrate (1) and the coating source (8) to prevent coating of areas other than the surface of the substrate (1) to be coated,
wherein
the first shield (3)comprises a moving apparatus (11) and a coupling device (7) for coupling the first shield (3) and the substrate carrier (2), so that first shield (3) and substrate carrier (2) are movable together transverse the coating direction.

2. Coating chamber according to claim 1,
**wherein**
the coating chamber is a vacuum chamber.

3. Coating chamber according to claim 1 or 2,
**wherein**
the coating source (8) is selected from a group comprising CVD sources, PECVD sources, PVD sources, sputter sources and vapour deposition sources.

4. Coating chamber according to any of the preceding claims,
**wherein**
the coating source (8) is configured to define a coating area where a deposition rate is higher than a predetermined value, with the coating area being smaller than the substrate surface to be coated in at least one dimension.

5. Coating chamber according to any of the preceding claims,
**wherein**
the coating source (8) comprises one or several treatment tools being arranged in a way to form a coating source (8) extending over a specific area of the coating chamber.

6. Coating chamber according to claim 5,
**wherein**
the treatment tool is selected from the group comprising electrodes, magnetron electrodes, showerhead electrodes, rotatable electrodes, twin electrodes, microwave sources, heaters, sputter targets, gas inlets, and evaporation sources.

7. Coating chamber according to any of the preceding claims,
**wherein**
the transport device (5) is adapted to arrange the substrate carrier (2) with the substrate (1) to be coated in several coating positions with respect to the coating source (8).

8. Coating chamber according to any of the preceding claims,
**wherein**
the transport device (5) is adapted to oscillate the substrate carrier (2) with the substrate (1) with respect to the coating source (8).

9. Coating chamber according to any of the preceding claims,
**wherein**
the transport device (5) is configured in a way that a transport direction of the transport device (5) is transverse to a length direction of the coating source.

10. Coating chamber according to claim 4,
**wherein**
the transport device (5) is configured in a way that
a transport direction of the transport device (5) is parallel to a direction along which the coating area is smaller than the substrate surface to be coated.

11. Coating chamber according to any of the preceding claims,
**wherein**
the transport device (5) comprises a drive (13) and / or a guide device.

12. Coating chamber according to claim 11,
**wherein**
the transport device (5) is adapted for upright transport of plate-like substrates (1) and / or the guide device (6) comprises a support (15,16) defining a transport path and an opposing guide rail (24).

13. Coating chamber according to claim 11 or 12,
**wherein**
the transport device (5) comprises rolls (15,16) for supporting and / or driving the substrate carrier (2).

14. Coating chamber according to claim 11 or 12,
**wherein**
the guide device (6) comprises a contactless guide or a magnetic guide.

15. Coating chamber according to any of the preceding claims,
**wherein**
the transport device (5) comprises several guide devices (6) defining several transport paths which are arranged parallel to each other.

16. Coating chamber according to any of the preceding claims,
**wherein**
the moving apparatus (11) for the first shield (3)comprises at least one (13) drive and / or at least one guide apparatus.

17. Coating chamber according to claim 16,
**wherein**
the moving apparatus (11) is adapted for moving of a ring-like shield and/or the guide apparatus (12) comprises a shield support (17) defining a shield transport path and an opposing shield guide rail (21).

18. Coating chamber according to claim 16 or 17,
**wherein**
the moving apparatus (11) comprises rolls, (17) for supporting and / or driving the shield (3).

19. Coating chamber according to claim 16 or 17,
**wherein**
the guide apparatus (12) comprises a contactless guide or a magnetic guide.

20. Coating chamber according to any of the preceding claims,
**wherein**
the transport device (5) and the moving apparatus (11) have a single common drive or several independent drives.

21. Coating chamber according to any of the preceding claims,
**wherein**
the coupling device (7) comprises form fit elements.

22. Coating chamber according to any of the preceding claims,
**wherein**
the transport device (5) and / or the moving apparatus (11) are at least partially movable to each other and / or with respect to the coating source (8).

23. Coating chamber according to any of the preceding claims,
**wherein**
the transport device (5) and / or the moving apparatus (11) are at least partially movable transverse to a transport direction of the substrate carrier (2) and / or in a coating direction from the coating source (8) to the substrate (1) to be coated.

24. Coating chamber according to any of the preceding claims,
**wherein**
the transport device (5) and / or the moving apparatus (14) comprise guide rails (24, 21) which are arranged side by side to each other and have the same distance from opposing supports (15, 16, 17) or are arranged one behind the other and have different distances from opposing supports (15, 16, 17).

25. Coating chamber according to any of the preceding claims,
**wherein**
at least one second shield (4) is provided for, the second shield (4) being fixed with respect to the coating source (8).

26. Coating chamber according to claim 25,
**wherein**
the second shield (4) covers the first shield (3) and / or the moving apparatus (11).

27. Coating chamber according to any of the preceding claims,
**wherein**
the first shield (3) covers an area surrounding the surface of the substrate (1) to be coated and /or the substrate carrier (2).

28. Coating chamber according to any of the preceding claims,
**wherein**
the moving apparatus (11) of the first shield (3) is designed such that the first shield (3) is only movable in the chamber.

29. Method of operating a coating chamber comprising the steps of:
providing a substrate (1) on a substrate carrier (2),
selecting of one operation mode of different operation modi, wherein
a first operation mode comprises continuous movement of the substrate carrier (2) through a coating area of the coating chamber transverse a coating direction extending from the coating source to the substrate with a movable shield of the coating chamber being kept stationary during coating,
a second operation mode comprises
moving the substrate carrier with the substrate into a coupling position,
coupling the substrate carrier (2) with a movable shield provided in the coating chamber,
and
moving the substrate carrier (2) and the movable shield (3) transverse a coating direction extending from the coating source to the substrate in at least a further position so that
the substrate (1) is coated in at least two different positions with respect to a coating source (8), and
a third operation mode comprises stationary coating of the substrate (1) with the movable shield (3) of the coating chamber being kept stationary during coating.

30. Method according to claim 29,
**wherein**
in the second operation mode the substrate carrier (2) and the movable shield (3) are oscillated so that the substrate carrier (2) and the movable shield (3) are repeatedly moved through a coating area of the coating chamber.

## Patentansprüche

1. Beschichtungskammer umfassend:
eine Beschichtungsquelle (8);
eine Transportvorrichtung (5) zum Bewegen eines Substratträgers (2), der angepasst ist, ein zu beschichtendes Substrat (1) zu tragen, in mindestens eine Beschichtungsposition relativ zur Beschichtungsquelle (8), so dass das Substrat (1) beschichtet werden kann, wobei die Transportvorrichtung (5) in eine Richtung quer zu einer Beschichtungsrichtung, die sich von der Beschichtungsquelle zum Substrat erstreckt, bewegbar ist; und
mindestens eine erste Abschirmung (3), die in einem Bereich zwischen der Beschichtungsposition des Substrats (1) und der Beschichtungsquelle (8) bewegbar angeordnet ist, um eine Beschichtung von anderen Bereichen als der Oberfläche des zu beschichtenden Substrats (1) zu verhindern,
wobei die erste Abschirmung eine Bewegungseinrichtung (11) und eine Kopplungsvorrichtung (7) zum Koppeln der ersten Abschirmung (3) und des Substratträgers (2) umfasst, so dass die erste Abschirmung (3) und der Substratträger (2) gemeinsam quer zur Beschichtungsrichtung bewegbar sind.

2. Beschichtungskammer nach Anspruch 1, wobei die Beschichtungskammer eine Vakuumkammer ist.

3. Beschichtungskammer nach Anspruch 1 oder 2, wobei die Beschichtungsquelle (8) aus einer Gruppe ausgewählt ist, die CVD-Quellen, PECVD-Quellen, PVD-Quellen, Kathodenzerstäubungsquellen und Gasphasenabscheidungsquellen umfasst.

4. Beschichtungskammer nach einem der vorherigen Ansprüche, wobei die Beschichtungsquelle (8) konfiguriert ist, um einen Beschichtungsbereich zu bestimmen, in dem einen Abscheiderate höher als ein vorgegebener Wert ist, wobei der Beschichtungsbereich in zumindest einer Raumrichtung kleiner als die zu beschichtende Substratfläche ist.

5. Beschichtungskammer nach einem der vorherigen Ansprüche, wobei die Beschichtungsquelle (8) ein oder mehrere Behandlungsgeräte umfasst, die auf eine Weise angeordnet sind, um einen Beschichtungsquelle (8) auszubilden, die sich über einen spezifischen Bereich der Beschichtungskammer erstreckt.

6. Beschichtungskammer nach Anspruch 5, wobei das Behandlungsgerät aus der Gruppe ausgewählt ist, die Elektroden, Magnetronelektroden, Duschkopfelektroden, drehbare Elektroden, Zwillingselektroden, Mikrowellenquellen, Heizvorrichtungen, Kathodenzerstäubungstargets, Gaseinlässe und Verdampfungsquellen umfasst.

7. Beschichtungskammer nach einem der vorherigen Ansprüche, wobei die Transportvorrichtung (5) angepasst ist, um den Substratträger (2) mit dem zu beschichtenden Substrat (1) in mehrere Beschichtungspositionen relativ zur Beschichtungsquelle (8) anzuordnen.

8. Beschichtungskammer nach einem der vorherigen Ansprüche, wobei die Transportvorrichtung (5) angepasst ist, um den Substratträger (2) mit dem Substrate (1) relativ zur Beschichtungsquelle (8) zu oszillieren.

9. Beschichtungskammer nach einem der vorherigen Ansprüche, wobei die Transportvorrichtung (5) auf eine Weise konfiguriert ist, dass eine Transportrichtung der Transportvorrichtung (5) quer zu einer Längsrichtung der Beschichtungsquelle ist.

10. Beschichtungskammer nach Anspruch 4, wobei die Transportvorrichtung (5) auf eine Weise konfiguriert ist, dass eine Transportrichtung der Transportvorrichtung (5) parallel zu einer Richtung ist, entlang derer der Beschichtungsbereich kleiner als die zu beschichtende Substratfläche ist.

11. Beschichtungskammer nach einem der vorherigen Ansprüche, wobei die Transportvorrichtung (5) einen Antrieb (13) und/oder eine Führungsvorrichtung umfasst.

12. Beschichtungskammer nach Anspruch 11, wobei die Transportvorrichtung (5) zum senkrechten Transport eines plattenförmigen Substrats (1) angepasst ist und/oder die Führungsvorrichtung (6) eine Stütze (15, 16), die einen Transportpfad bestimmt, und eine gegenüberliegende Führungsschiene (24) umfasst.

13. Beschichtungskammer nach Anspruch 11 oder 12, wobei die Transportvorrichtung (5) Rollen (15, 16) zum Stützen und/oder Antreiben des Substratträgers (2) umfasst.

14. Beschichtungskammer nach Anspruch 11 oder 12, wobei die Führungsvorrichtung (6) eine kontaktlose Führung oder eine magnetische Führung umfasst.

15. Beschichtungskammer nach einem der vorherigen Ansprüche, wobei die Transportvorrichtung (5) mehrere Führungsvorrichtung (6) umfasst, die mehrere Transportpfade bestimmen, die parallel zueinander angeordnet sind.

16. Beschichtungskammer nach einem der vorherigen Ansprüche, wobei die Bewegungseinrichtung (11) für die erste Abschirmung (3) mindestens einen Antrieb (13) und/oder mindestens eine Führungseinrichtung umfasst.

17. Beschichtungskammer nach Anspruch 16, wobei die Bewegungseinrichtung (11) zum Bewegen einer ringförmigen Abschirmung angepasst ist und/oder die Führungseinrichtung (12) eine Abschirmungsstütze (17), die einen Abschirmungstransportpfad bestimmt, und eine gegenüberliegende Abschirmungsführungsschiene (21) umfasst.

18. Beschichtungskammer nach Anspruch 16 oder 17, wobei die Bewegungseinrichtung (11) Rollen (17) zum Stützen und/oder Antreiben der Abschirmung (3) umfasst.

19. Beschichtungskammer nach Anspruch 16 oder 17, wobei die Führungseinrichtung (12) eine kontaktlose Führung oder eine magnetische Führung umfasst.

20. Beschichtungskammer nach einem der vorherigen Ansprüche, wobei die Transportvorrichtung (5) und die Bewegungseinrichtung (11) einen einzigen gemeinsamen Antrieb oder mehrere unabhängige Antriebe aufweisen.

21. Beschichtungskammer nach einem der vorherigen Ansprüche, wobei die Kopplungsvorrichtung (7) Formschlusselemente umfasst.

22. Beschichtungskammer nach einem der vorherigen Ansprüche, wobei die Transportvorrichtung (5) und/oder die Bewegungseinrichtung (11) zumindest teilweise relativ zueinander und/oder relativ zur Beschichtungsquelle (8) bewegbar sind.

23. Beschichtungskammer nach einem der vorherigen Ansprüche, wobei die Transportvorrichtung (5) und/oder die Bewegungseinrichtung (11) zumindest teilweise quer zu einer Transportrichtung des Substratträgers (2) und/oder in einer Beschichtungsrichtung von der Beschichtungsquelle (8) zum zu beschichtenden Substrat (1) bewegbar sind.

24. Beschichtungskammer nach einem der vorherigen Ansprüche, wobei die Transportvorrichtung (5) und/oder die Bewegungseinrichtung (11) Führungsschienen (24, 21) umfassen, die nebeneinander angeordnet sind und denselben Abstand von gegenüberliegenden Stützen (15, 16, 17) aufweisen oder eine hinter der anderen angeordnet sind und unterschiedliche Abstände von gegenüberliegenden Stützen (15, 16, 17) aufweisen.

25. Beschichtungskammer nach einem der vorherigen Ansprüche, wobei mindestens eine zweite Abschirmung (4) vorgesehen ist, wobei die zweite Abschirmung (4) relativ zur Beschichtungsquelle (8) fest ist.

26. Beschichtungskammer nach Anspruch 25, wobei die zweite Abschirmung (4) die erste Abschirmung (3) und/oder die Bewegungseinrichtung (11) abdeckt.

27. Beschichtungskammer nach einem der vorherigen Ansprüche, wobei die erste Abschirmung einen Bereich, der die Oberfläche des zu beschichtenden Substrats (1) umgibt, und/oder den Substratträger (2) abdeckt.

28. Beschichtungskammer nach einem der vorherigen Ansprüche, wobei die Bewegungseinrichtung (11) der ersten Abschirmung (3) ausgebildet ist, so dass die erste Abschirmung (3) nur innerhalb der Kammer bewegbar ist.

29. Verfahren zum Betreiben einer Beschichtungskammer umfassend die Schritte:
Bereitstellen eines Substrats (1) auf einem Substratträger (2);
Auswählen eines Betriebsmodus unter verschiedenen Betriebsmodi, wobei ein erster Betriebsmodus umfasst:
kontinuierliches Bewegen des Substratträgers (2) durch einen Beschichtungsbereich der Beschichtungskammer quer zu einer Beschichtungsrichtung, die sich von der Beschichtungsquelle bis zum Substrat erstreckt, mit einer während dem Beschichten stationär gehaltenen bewegbare Abschirmung der Beschichtungskammer;
ein zweiter Betriebsmodus umfasst:
Bewegen des Substratträgers (2) mit dem Substrat (1) in eine Kopplungsposition,
Koppeln des Substratträgers (2) mit einer bewegbaren Abschirmung, die in der Beschichtungskammer bereitgestellt ist, und
Bewegen des Substratträgers (2) und der bewegbaren Abschirmung (3) quer zu einer Beschichtungsrichtung, die sich von der Beschichtungsquelle bis zum Substrat erstreckt, in zumindest eine weitere Position, so dass das Substrat (1) in mindestens zwei unterschiedlichen Positionen relativ zur Beschichtungsquelle (8) beschichtet wird; und
ein dritter Betriebsmodus umfasst:
stationäres Beschichten des Substrats (1) mit der während dem Beschichten stationär gehaltenen bewegbaren Abschirmung (3) der Beschichtungskammer.

30. Verfahren nach Anspruch 29, wobei im zweiten Betriebsmodus der Substratträger (2) und die bewegbare Abschirmung (3) oszilliert werden, so dass der Substratträger (2) und die bewegbare Abschirmung (3) wiederholt durch einen Beschichtungsbereich der Beschichtungskammer bewegt werden.

## Revendications

1. Chambre de revêtement comprenant :
une source de revêtement (8),
un dispositif de transport (5) destiné à déplacer un porte-substrat (2) adapté pour être apte à apporter un substrat (1) à revêtir dans au moins une position de revêtement par rapport à la source de revêtement (8) de sorte que le substrat (1) puisse être revêtu, le dispositif de transport (5) étant déplaçable dans une direction transversale à la direction de revêtement, la direction de revêtement s'étendant depuis la source de revêtement vers le substrat et
au moins un premier écran (3) agencé de manière déplaçable dans une zone entre la position de revêtement du substrat (1) et la source de revêtement (8) pour empêcher le revêtement de zones autres que la surface du substrat (1) à revêtir,
sachant que
le premier écran (3) comprend un appareil de déplacement (11) et un dispositif de couplage (7) destiné à coupler le premier écran (3) et le porte-substrat (2), de sorte que le premier écran (3) et le porte-substrat (2) puissent être déplacés ensemble transversalement à la direction de revêtement.

2. Chambre de revêtement selon la revendication 1,
sachant que
la chambre de revêtement est une chambre à vide.

3. Chambre de revêtement selon la revendication 1 ou 2,
sachant que
la source de revêtement (8) est sélectionnée dans un groupe comprenant des sources CVD, des sources PECVD, des sources PVD, des sources de pulvérisation et des sources de dépôt par vapeur.

4. Chambre de revêtement selon l'une quelconque des revendications précédentes,
sachant que
la source de revêtement (8) est configurée pour définir une zone de revêtement où un taux de dépôt est supérieur à une valeur prédéterminée, la zone de revêtement étant plus petite que la surface de substrat à revêtir dans au moins une dimension.

5. Chambre de revêtement selon l'une quelconque des revendications précédentes,
sachant que
la source de revêtement (8) comprend un ou plusieurs outils de traitement agencé(s) de manière à former une source de revêtement (8) s'étendant sur une zone spécifique de la chambre de revêtement.

6. Chambre de revêtement selon la revendication 5,
sachant que
l'outil de traitement est sélectionné dans le groupe comprenant des électrodes, des électrodes de magnétron, des électrodes de diffuseur en pomme d'arrosoir, des électrodes rotatives, des électrodes jumelles, des sources de microondes, des chauffages, des cibles de pulvérisation, des entrées de gaz, et des sources d'évaporation.

7. Chambre de revêtement selon l'une quelconque des revendications précédentes,
sachant que
le dispositif de transport (5) est apte à agencer le porte-substrat (2) avec le substrat (1) à revêtir dans plusieurs positions de revêtement par rapport à la source de revêtement (8).

8. Chambre de revêtement selon l'une quelconque des revendications précédentes,
sachant que
le dispositif de transport (5) est apte à faire osciller le porte-substrat (2) avec le substrat (1) par rapport à la source de revêtement (8).

9. Chambre de revêtement selon l'une quelconque des revendications précédentes,
sachant que
le dispositif de transport (5) est configuré de telle manière qu'une direction de transport du dispositif de transport (5) soit transversale à une direction de longueur de la source de revêtement.

10. Chambre de revêtement selon la revendication 4,
sachant que
le dispositif de transport (5) est configuré de telle manière qu'une direction de transport du dispositif de transport (5) soit parallèle à une direction le long de laquelle la zone de revêtement est plus petite que la surface de substrat à revêtir.

11. Chambre de revêtement selon l'une quelconque des revendications précédentes,
sachant que
le dispositif de transport (5) comprend un entraînement (13) et/ou un dispositif de guidage.

12. Chambre de revêtement selon la revendication 11,
sachant que
le dispositif de transport (5) est apte à transporter debout des substrats (1) en forme de plaques et/ou le dispositif de guidage (6) comprend un support (15, 16) définissant un chemin de transport et un rail de guidage opposé (24).

13. Chambre de revêtement selon la revendication 11 ou 12,
sachant que
le dispositif de transport (5) comprend des rouleaux (15, 16) destinés à supporter et/ou entraîner le porte-substrat (2).

14. Chambre de revêtement selon la revendication 11 ou 12,
sachant que
le dispositif de guidage (6) comprend un guide sans contact ou un guide magnétique.

15. Chambre de revêtement selon l'une quelconque des revendications précédentes,
sachant que
le dispositif de transport (5) comprend plusieurs dispositifs de guidage (6) définissant plusieurs chemins de transport qui sont agencés parallèlement les uns aux autres.

16. Chambre de revêtement selon l'une quelconque des revendications précédentes,
sachant que
l'appareil de déplacement (11) pour le premier écran (3) comprend au moins un entraînement (13) et/ou au moins un appareil de guidage.

17. Chambre de revêtement selon la revendication 16,
sachant que
l'appareil de déplacement (11) est apte à déplacer un écran de forme annulaire et/ou l'appareil de guidage (12) comprend un support d'écran (17) définissant un chemin de transport d'écran et un rail de guidage d'écran opposé (21).

18. Chambre de revêtement selon la revendication 16 ou 17,
sachant que
l'appareil de déplacement (11) comprend des rouleaux (17) destinés à supporter et/ou entraîner l'écran (3).

19. Chambre de revêtement selon la revendication 16 ou 17,
sachant que
l'appareil de guidage (12) comprend un guide sans contact ou un guide magnétique.

20. Chambre de revêtement selon l'une quelconque des revendications précédentes,
sachant que
le dispositif de transport (5) et l'appareil de déplacement (11) ont un entraînement commun unique ou plusieurs entraînements indépendants.

21. Chambre de revêtement selon l'une quelconque des revendications précédentes,
sachant que
le dispositif de couplage (5) comprend des éléments ajustés en termes de forme.

22. Chambre de revêtement selon l'une quelconque des revendications précédentes,
sachant que
le dispositif de transport (5) et/ou l'appareil de déplacement (11) sont au moins en partie déplaçables l'un vers l'autre et/ou par rapport à la source de revêtement (8).

23. Chambre de revêtement selon l'une quelconque des revendications précédentes,
sachant que
le dispositif de transport (5) et/ou l'appareil de déplacement (11) sont au moins en partie déplaçables transversalement à une direction de transport du porte-substrat (2) et/ou dans une direction de revêtement depuis la source de revêtement (8) vers le substrat (1) à revêtir.

24. Chambre de revêtement selon l'une quelconque des revendications précédentes,
sachant que
le dispositif de transport (5) et/ou l'appareil de déplacement (14) comprennent des rails de guidage (24, 21) qui sont agencés côte à côte l'un de l'autre et sont à la même distance de supports opposés (15, 16, 17) ou sont agencés l'un derrière l'autre et sont à des distances différentes de supports opposés (15, 16, 17).

25. Chambre de revêtement selon l'une quelconque des revendications précédentes,
sachant que
au moins un deuxième écran (4) est prévu, le deuxième écran (4) étant fixe par rapport à la source de revêtement (8).

26. Chambre de revêtement selon la revendication 25,
sachant que
le deuxième écran (4) couvre le premier écran (3) et/ou l'appareil de déplacement (11).

27. Chambre de revêtement selon l'une quelconque des revendications précédentes,
sachant que
le premier écran (3) couvre une zone entourant la surface du substrat (1) à revêtir et/ou le porte-substrat (2).

28. Chambre de revêtement selon l'une quelconque des revendications précédentes,
sachant que
l'appareil de déplacement (11) du premier écran (3) est conçu de telle sorte que le premier écran (3) soit seulement déplaçable dans la chambre.

29. Procédé de fonctionnement d'une chambre de revêtement comprenant les étapes consistant à :
disposer un substrat (1) sur un porte-substrat (2),
sélectionner un mode de fonctionnement parmi différents modes de fonctionnement, sachant que
un premier mode de fonctionnement comprend le mouvement continu du porte-substrat (2) à travers une zone de revêtement de la chambre de revêtement transversalement à une direction de revêtement s'étendant depuis la source de revêtement vers le substrat, un écran déplaçable de la chambre de revêtement étant maintenu de façon stationnaire pendant le revêtement,
un deuxième mode de fonctionnement comprend
le déplacement du porte-substrat avec le substrat dans une position de couplage,
le couplage du porte-substrat (2) avec un écran déplaçable disposé dans la chambre de revêtement,
et
le déplacement du porte-substrat (2) et de l'écran déplaçable (3) transversalement à une direction de revêtement s'étendant depuis la source de revêtement vers le substrat dans au moins une position supplémentaire de sorte que
le substrat (1) soit revêtu dans au moins deux positions différentes par rapport à une source de revêtement (8), et
un troisième mode de fonctionnement comprend le revêtement stationnaire du substrat (1), l'écran déplaçable (3) de la chambre de revêtement étant maintenu de façon stationnaire pendant le revêtement.

30. Procédé selon la revendication 29,
sachant que
dans le deuxième mode de fonctionnement, le porte-substrat (2) et l'écran déplaçable (3) sont mis en oscillation de sorte que le porte-substrat (2) et l'écran déplaçable (3) soient déplacés de manière répétée à travers une zone de revêtement de la chambre de revêtement.
